# EUROPÄISCHE PATENTSCHRIFT

(11) **EP 3 781 401 B1**
(45) Veröffentlichungstag und Bekanntmachung des Hinweises auf die Patenterteilung: **27.04.2022**
(21) Anmeldenummer: 19718667.9
(22) Anmeldetag: 16.04.2019
(51) Int. Cl.: B41F 15/08, H05K 3/12, H05K 3/00, H01L 21/677, H01L 21/67, B65H 5/04, B41J 11/00, B41J 3/407, B41F 15/26, B41J 11/06

(54) **DRUCKSYSTEM ZUM BEDRUCKEN VON SUBSTRATEN SOWIE VERFAHREN ZUM BETREIBEN DES DRUCKSYSTEMS**
PRINTING SYSTEM FOR PRINTING SUBSTRATES AS WELL AS METHOD FOR OPERATING THE PRINTING SYSTEM
SYSTÈME D'IMPRESSION POUR IMPRIMER DES SUBSTRATS AINSI QUE PROCÉDÉ DE FONCTIONNEMENT DU SYSTÈME D'IMPRESSION

(30) Priorität: 18.04.2018 DE 102018205944
(43) Veröffentlichungstag der Anmeldung: 24.02.2021
(73) Patentinhaber: EKRA Automatisierungssysteme GmbH, 74357 Bönnigheim (DE)
(72) Erfinder: VEGELAHN, Torsten, 75447 Sternenfels (DE); SZEKERESCH, Jakob, 75328 Schömberg (DE)
(74) Vertreter: Clarenbach, Carl-Philipp
(86) Internationale Anmeldenummer: PCT/EP2019/059734
(87) Internationale Veröffentlichungsnummer: WO 2019/201886

(56) Entgegenhaltungen:
- EP-A1- 2 711 183
- EP-A2- 2 094 071
- WO-A1-2017/022127
- US-A1- 2005 284 366
- US-A1- 2012 288 635
- US-B1- 9 555 646

## Beschreibung

Die Erfindung betrifft ein Drucksystem zum Bedrucken von Substraten, insbesondere Leiterplatten, Wafern oder Solarzellen, mit einer Druckeinrichtung, die einen Drucktisch, auf welchem die Substrate positionierbar sind, und einen dem Drucktisch zugeordneten Druckkopf zum Bedrucken der auf dem Drucktisch positionierten Substrate aufweist, mit einer Zuführeinrichtung zum Zuführen der zu bedruckenden Substrate zu der Druckeinrichtung und mit einer Abführeinrichtung zum Abführen der bedruckten Substrate aus der Druckeinrichtung, und mit mehreren Substratauflagen, auf welchen jeweils mehrere Substrate auflegbar sind, wobei Zuführeinrichtung, Druckeinrichtung und Abführeinrichtung dazu ausgebildet sind, die Substratauflagen mit den darauf befindlichen Substraten zu befördern. Weiterhin betrifft die Erfindung ein Verfahren zum Betreiben eines derartigen Drucksystems. Drucksysteme der eingangs genannten Art sind aus dem Stand der Technik bekannt. Zum Bedrucken von Leiterplatten sind beispielsweise Sieb-Druckeinrichtungen bekannt, mit einem Drucktisch, auf welchem ein oder mehrere zu bedruckende Substrate positionierbar sind, und mit einem Druckkopf, der beispielsweise ein Drucksieb und ein Druckrakel aufweist, die dazu ausgebildet sind, die auf dem Drucktisch positionierten Substrate mit einer Druckmasse oder - Paste, die mittels des Rakels durch das Drucksieb hindurchgedrückt wird, zu bedrucken. Um eine Automatisierung eines derartigen Drucksystems zu ermöglichen, ist es bekannt, der Druckeinrichtung eine Zuführeinrichtung vor- und eine Abführeinrichtung nachzuschalten, mittels welcher die Substrate dem Drucktisch automatisiert zugeführt und von der Druckeinrichtung abgeführt werden. Um den Durchsatz eines derartigen Drucksystems zu erhöhen, ist es außerdem bekannt, dass mehrere Substrate gleichzeitig befördert und bedruckt werden. Um diesen Vorgang zu vereinfachen ist es bekannt, mehrere Substrate auf eine Substratauflage, wie beispielsweise Halteplatte, Tray oder dergleichen, anzuordnen und die Substratauflage der Druckeinrichtung zuzuführen. Dadurch ist die Handhabung einer Vielzahl von Subtraten gleichzeitig einfach und kostengünstig bewerkstelligt.

Die Offenlegungsschrift US 2005/284366 A1 offenbart ein System zum Beschichten von Substraten mit einer Beschichtung. Um das Beschichten mehrerer Substrate gleichzeitig zu ermöglichen, werden mehrere Substrate manuell in einem Haltegestell oder Käfig bereitgestellt.

Ferner beschreibt die Schrift EP 2 711 183 A1 bzw. DE 10 2012 019 573 A1 ein Drucksystem gemäß dem Oberbegriff des Anspruchs 1.

Der Erfindung liegt die Aufgabe zugrunde, das oben genannte Drucksystem dahingehend zu verbessern, dass die Handhabbarkeit vereinfacht und der Durchsatz noch weiter erhöht werden.

Die der Erfindung zugrundeliegende Aufgabe wird durch ein Drucksystem mit den Merkmalen des Anspruchs 1 gelöst. Dieses hat den Vorteil, dass mehrere Vorgänge gleichzeitig erfolgen können, sodass die Stillstandzeit insbesondere der Druckeinrichtung auf ein Minimum reduziert wird.

Das erfindungsgemäße Drucksystem zeichnet sich dadurch aus, dass die Zuführeinrichtung dazu ausgebildet ist, mehrere Substratauflagen zu sammeln und gesammelt der Druckeinrichtung zuzuführen, wobei die Druckeinrichtung dazu ausgebildet ist, die Substrate auf den gesammelten Substratauflagen zu bedrucken, und dass die Abführeinrichtung dazu ausgebildet ist, die gesammelten Substratauflagen abzuführen und zu vereinzeln. Durch die Zuführeinrichtung erfolgt also ein Sammeln mehrerer Substrate, die nach dem Druckvorgang durch die Abführeinrichtung wieder vereinzelt werden. Dadurch, dass die Substratauflagen gesammelt der Druckeinrichtung zu und von dieser abgeführt werden, ergibt sich der Vorteil, dass während des Sammelns und Vereinzeln der Substratauflagen in der Druckeinrichtung ein Druckvorgang auf den dort befindlichen Substraten der gesammelten Substratauflagen durchführbar ist. Somit können gleichzeitig zu einem Druckvorgang Substratauflagen gesammelt und vereinzelt werden, wodurch der Gesamtdurchsatz des Drucksystems optimiert und Stillstandzeiten des Drucksystems minimiert werden.

Gemäß einer bevorzugten Ausführungsform der Erfindung weist die Zuführeinrichtung eine Sammeleinrichtung auf, die einen verlagerbaren ersten Anschlag aufweist, gegen welchen die Substratauflagen zum Sammeln förderbar sind. Durch den ersten Anschlag ist es besonders einfach, mehrere Substratauflagen zu sammeln. Dazu müssen diese lediglich gegen den ersten Anschlag gefördert werden, sodass sie dort gruppiert werden. Insbesondere dann, wenn die Substratauflagen nacheinander gegen den ersten Anschlag gefördert werden, entsteht eine Reihe von hintereinanderliegenden Substratauflagen, die sich direkt oder indirekt an dem ersten Anschlag abstützen. Erst wenn der erste Anschlag verlagert wird, sodass er die Bewegung der Substratauflagen nicht mehr behindert, können die zuvor an dem Anschlag gesammelten Substratauflagen durch die Zuführeinrichtung auf den Drucktisch der Druckeinrichtung befördert werden. Hierdurch ist ein einfaches Sammeln und Befördern der Substratauflagen gewährleistet.

Insbesondere weist die Sammeleinrichtung mehrere freidrehbar gelagerte Rollen auf, auf welchen die Substratauflagen sammelbar sind. Durch die freidrehbar gelagerten Rollen ist ein Zusammenführen der Substratauflagen reibungsfrei und damit energiearm ermöglicht.

Weiterhin ist bevorzugt vorgesehen, dass die Zuführeinrichtung eine Fördereinrichtung zum Verschieben der gesammelten Substratauflagen auf den Drucktisch aufweist. Mittels der Fördereinrichtung werden somit die Substratauflagen gesammelt und insbesondere gesammelt auf den Drucktisch verschoben, insbesondere nachdem der verlagerbare erste Anschlag in seine Freigabeposition verlagert wurde. Hierzu sind Fördereinrichtung und erster Anschlag insbesondere mechanisch und/oder elektrisch miteinander gekoppelt, um eine Synchronisation der Bewegungen zu ermöglichen. Gleichzeitig ist die Fördereinrichtung insbesondere dazu ausgebildet, die Substratauflagen gegen den ersten Anschlag zu bewegen beziehungsweise zu fördern und dadurch die Substratauflagen zu sammeln.

Die Fördereinrichtung weist dazu bevorzugt zumindest einen verschiebbaren Mitnahmeanschlag, zumindest einen antreibbaren Förderriemen und/oder zumindest eine angetriebene Förderrolle auf, die zum Verlagern der Substratauflagen ausgebildet sind. Der Förderriemen ist insbesondere derart ausgebildet, dass die Haftreibung zwischen Substratauflagen und Förderriemen derart gering ist, dass sobald die Substratauflage gegen den ersten Anschlag oder gegen eine bereits an dem Anschlag anliegende Substratauflage treffen, der Förderriemen weiter bewegbar ist, ohne die Substratauflage zu beschädigen oder zu verschieben. Der verschiebbare Mitnahmeanschlag ist dazu ausgebildet, mit der jeweiligen Substratauflage insbesondere formschlüssig zusammenzuwirken, um diese auf den frei drehbar gelagerten Rollen zu bewegen. Dazu liegt der Mitnahmeanschlag insbesondere neben einer Reihe von frei drehbar gelagerten Rollen oder zwischen zwei parallel und beabstandet zueinander angeordneten Reihen von frei drehbar gelagerten Rollen und ragt derart weit nach oben in Richtung der Substratauflagen, dass er diese formschlüssig in Richtung des Anschlags bewegen kann. Insbesondere ist der Mitnahmeanschlag auf einer Spindel eines Spindelantriebs derart angeordnet, dass er durch eine Rotationsbewegung der Spindel translatorisch entlang der Spindel verschoben wird. Optional ist der Mitnahmeanschlag und/oder die Fördereinrichtung insgesamt in der Höhe verstellbar, um ein Zusammenwirken mit einer Substratauflage herzustellen oder zu lösen. Bei der zumindest einen angetriebenen Förderrolle handelt es sich insbesondere um eine der Rollen, die mit einem ansteuerbaren Antrieb wirkverbunden ist.

Bevorzugt weist der Drucktisch Mittel zum Transportieren und Ausrichten der Substratauflagen auf. Insbesondere weist der Drucktisch dabei bekannte Fördermittel auf, die bereits bei Druckeinrichtungen eingesetzt werden, wie beispielsweise Förderrollen. Insbesondere sind der Drucktisch und/oder Druckkopf selbst verdreh- und in der Ebene verschiebbar, um eine optimale Ausrichtung der Substratauflagen in Bezug auf den Druckkopf und insbesondere in Bezug auf ein dort vorgesehenes Drucksieb auszurichten. Bevorzugt weist der Drucktisch zumindest einen zweiten verlagerbaren Anschlag auf, gegen welchen die Substratauflagen förderbar sind. Dadurch ist eine Grundpositionierung der Substratauflagen auf dem Drucktisch sicher gewährleistet. Bevorzugt weist der Drucktisch außerdem Führungsschienen auf, entlang welcher die Substratauflagen förderbar sind, sodass die Ausrichtung der Substratauflagen auf dem Drucktisch bekannt und wiederholbar ist. Optional weist der Drucktisch als Mittel zum Transportieren und Ausrichten der Substratauflagen eine Fördereinrichtung auf, wie sie zuvor beschrieben wurde.

Weiterhin ist bevorzugt vorgesehen, dass die Abführeinrichtung mehrere freidrehbar gelagerte Rollen zur Aufnahme und zum Transport der Substratauflagen aufweist. Nach erfolgtem Druckvorgang fördert bevorzugt die Druckeinrichtung selbst die gesammelten Substratauflagen mit den bedruckten Substraten in Richtung der Abführeinrichtung. Aufgrund der frei verdrehbar gelagerten Rollen werden die Substratauflagen dort automatisch und ohne weiteres Zutun beziehungsweise ohne weitere Aktorik aufgenommen.

Besonders bevorzugt weist die Abführeinrichtung eine Vereinzelungseinrichtung zum Vereinzeln und Abführen der Substratauflagen auf. Die Vereinzelungseinrichtung ist dazu ausgebildet, die gesammelten und aus der Druckeinrichtung herausgeförderten Substratauflagen zu vereinzeln und insbesondere nacheinander abzuführen, beispielsweise in Richtung einer nachgeschalteten Bearbeitungsanlage.

Die Vereinzelungseinrichtung weist bevorzugt einen dritten Anschlag auf, gegen welchen die Substratauflagen zunächst förderbar sind, und mittels dessen ein Vereinzeln beziehungsweise ein einzelnes oder vereinzeltes Weitertransportieren der Substratauflagen ermöglicht ist. Der dritte Anschlag wirkt insbesondere mit einer dritten Fördereinrichtung der Vereinzelungseinrichtung zusammen, die dazu ausgebildet ist, die Substratauflagen weiter zu fördern. Insbesondere ist dabei der Anschlag derart verlagerbar, dass die Substratauflagen nur nacheinander vereinzelt von der Abführeinrichtung weiter transportiert werden.

Gemäß einer bevorzugten Weiterbildung der Erfindung weist die Abführeinrichtung eine Fördereinrichtung auf, die einen verschiebbaren Mitnahmeanschlag, zumindest einen antreibbaren Förderriemen und/oder zumindest eine angetriebene Förderrolle aufweist. Die Fördereinrichtung der Abführeinrichtung ist vorzugsweise zumindest im Wesentlichen wie die Fördereinrichtung der Zuführeinrichtung ausgebildet, um durch Verwendung von Gleichteilen eine kostengünstige Lösung zu schaffen. Bevorzugt weist die Fördereinrichtung sowohl in Förderrichtung vorne als auch hinten liegend angetriebene Förderrollen auf, die das Fördern und Bewegen der Substratauflagen erlauben. Zusätzlich weist die Fördereinrichtung bevorzugt den verschiebbaren Mitnahmeanschlag auf, der insbesondere zwischen den zwei parallel und beabstandet zueinander liegenden Reihen von Rollen der Abführeinrichtung in Fördereinrichtung insbesondere mittels eines Spindelantriebs verschiebbar ist.

Gemäß einer bevorzugten Weiterbildung der Erfindung sind die Druckeinrichtung, die Zuführeinrichtung und die Abführeinrichtung dazu ausgebildet, die Substratauflagen und Fördereinrichtung hintereinander zu sammeln und hintereinander liegend zu transportieren. Wie oben bereits erwähnt ergibt sich hierdurch ein besonders einfaches Sammeln und Vereinzeln der Substratauflagen. Gemäß einer alternativen Ausführungsform werden die Substratauflagen nebeneinanderliegend in Förderrichtung gesammelt und transportiert. Dazu werden beispielsweise die Substratauflagen nebeneinander gegen den ersten Anschlag der Sammeleinrichtung gefördert und anschließend, nach Verlagern des Anschlags in eine Freigabeposition, dem Drucktisch zugeführt.

Weiterhin ist bevorzugt vorgesehen, dass die Zuführeinrichtung, die Druckeinrichtung und die Abführeinrichtung jeweils mindestens einen Sensor zum Erfassen wenigstens einer Position zumindest einer Substratauflage aufweisen. Mittels des Sensors ist eine Überwachung des Sammelns, Vereinzelns und Bedrucken ermöglicht, sodass automatisch eingeschritten werden kann, falls ein unerwarteter Zustand eintritt, bei welchem beispielsweise eine Substratauflage vermisst oder nicht korrekt positioniert wird.

Das erfindungsgemäße Verfahren zum Betreiben des vorstehend beschriebenen Drucksystems zeichnet sich durch die Merkmale des Anspruchs 14 aus. Das Verfahren zeichnet sich durch die folgenden Schritte aus: In einem Schritt a) werden mehrere Substrate durch die Zuführeinrichtung in Fördereinrichtung hintereinanderliegend gesammelt. Hierzu dienen beispielsweise der zuvor bereits erwähnte erste Anschlag sowie die freidrehbar gelagerten Rollen. In einem Schritt b) werden die so gesammelten Substrate in die Druckeinrichtung und insbesondere auf den Drucktisch gefördert und dort optional von der Druckeinrichtung ausgerichtet und/oder positioniert, insbesondere in Relation zu einem Drucksieb des Druckkopfes. In einem Schritt c) werden die gesammelten Substrate in der Druckeinrichtung bedruckt, beispielsweise indem die Druckpaste oder -Masse mit einem Rakel durch das Drucksieb auf die darunter positionierten Substrate gedrückt wird. In einem Schritt d) werden die gesammelten Substrate nach erfolgtem Druckvorgang aus der Druckeinrichtung in die Abführeinrichtung gefördert oder transportiert. In einem Schritt e) werden die Substratauflagen in der Abführeinrichtung vereinzelt und nacheinander abgeführt. Es ergeben sich hierdurch die zuvor bereits genannten Vorteile.

Insbesondere erfolgen die Schritte a), c) und e) zumindest gleichzeitig, sodass ein besonders hoher Durchsatz von Substratauflagen durch das Drucksystem mit minimierten Stillstandzeiten gewährleistet ist. Es ergeben sich die zuvor bereits genannten Vorteile.

Weitere Vorteile und bevorzugte Merkmale und Merkmalskombinationen ergeben sich insbesondere aus dem zuvor Beschriebenen sowie aus den Ansprüchen. Im Folgenden soll die Erfindung anhand der Zeichnung näher erläutert werden. Dazu zeigen
- Figuren 1A und B: ein vorteilhaftes Drucksystem in einer Draufsicht und einer Seitenansicht und
- Figur 2: ein vorteilhaftes Verfahren zum Betreiben des Drucksystems in mehreren Schritten A bis D.

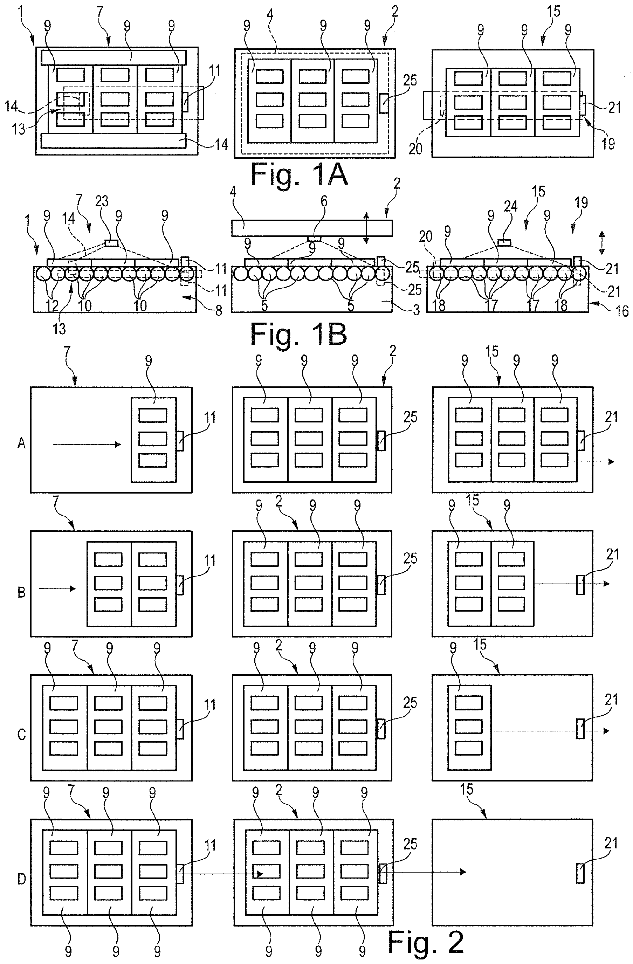

Figur 1 zeigt in einer Draufsicht (Figur 1A) und in einer Seitenansicht (Figur 1B) ein vorteilhaftes Drucksystem 1 zum Bedrucken von Substraten, wie beispielsweise Leiterplatten, Wafern oder Solarzellen. Das Drucksystem 1 weist eine Druckeinrichtung 2 auf, die einen Drucktisch 3, auf welchem die Substrate anordenbar sind, und einen oberhalb des Drucktischs 3 angeordneten Druckkopf 4 aufweist. Der Druckkopf 4 weist beispielsweise eine Rakeleinrichtung auf, mit einem Rakel und einem Drucksieb, mittels welcher eine Druckpaste in einer gewünschten Struktur auf die Substrate auf dem Drucktisch aufdruckbar ist. Der Drucktisch 3 ist dazu ausgebildet, die Substrate unterhalb des Druckkopfs 4 zu positionieren und insbesondere relativ zu dem Druckkopf 4 auszurichten, um einen exakten Druckvorgang zu ermöglichen. Dazu weist der Drucktisch 3 beispielsweise mehrere antreibbare Rollen 5 auf, die mit einem hier nicht dargestellten Antrieb wirkverbunden sind, der ansteuerbar ist, um die Substrate auf dem Drucktisch 3 auszurichten. Vorteilhafterweise ist dem Drucktisch 3 eine Sensoreinrichtung 6 mit einem oder mehreren Sensoren zum Erfassen der Position und Ausrichtung der Substrate auf dem Drucktisch 3 zugeordnet, um eine sichere Ausrichtung der Substrate zu dem Druckkopf 4 zu gewährleisten. Durch das Antreiben der Rollen 5 sind die Substrate auf der Druckeinrichtung 2 bewegbar und in diese hinein und aus dieser hinaus förderbar. Um die Handhabung der Substrate zu vereinfachen, weist das vorliegende Drucksystem 1 Substratauflagen 9 auf, auf welchen die Substrate ablegbar und zusammen der Druckeinrichtung 2 zuführbar sind. Dadurch wird der Durchsatz beim Bedrucken von Substraten auf einfache Art und Weise erhöht. Bevorzugt werden die Substrate auf den Substratauflagen 9 in der Druckeinrichtung 2 vollautomatisch ausgerichtet. Insbesondere weist dazu die Druckeinrichtung eine Justiereinrichtung zum Ausrichten der Substrate bezüglich des Druckkopfs 4 beziehungsweise insbesondere des Drucksiebs auf, wobei die Justiereinrichtung insbesondere eine Erfassungseinrichtung zum Erfassen der Lage der Substrate relativ zu dem Druckkopf 4 aufweist, sowie eine Greifeinrichtung, die dazu ausgebildet ist, jeweils ein Substrat zu greifen, von der Substratauflage 9 zu entfernen und nach erfolgter Ausrichtung wieder auf die Tragplatte abzusetzen. Zum Ausrichten werden die Greifeinrichtung und/oder die Substratauflage insbesondere in einer Ebene parallel zum Druckkopf 4 verschoben und/oder verdreht, während das Substrat von der Tragplatte entfernt ist. Insbesondere wird dabei vorgegangen, wie in der Patentanmeldung DE 10 2012 019 573 A1 beschrieben.

Um die Position der Substrate oder Substratauflagen auf dem Drucktisch 3 zu bestimmen, weist dieser bevorzugt einen verlagerbaren Anschlag 25 auf, der in eine Sperrstellung (durchgezogene Linie) auf Höhe der Substratauflagen liegt, und in einer Freigabestellung (gestrichelte Linie) aus dem Bewegungsweg der Substratauflagen 9 heraus bewegt ist.

In Förderrichtung vorgeschaltet ist der Druckeinrichtung 2 eine Zuführeinrichtung 7. Diese weist eine Sammeleinrichtung 8 zum Sammeln mehrerer Substratauflagen 9 auf. Die Sammeleinrichtung 8 weist dazu zumindest zwei Reihen von jeweils mehreren in Förderrichtung hintereinanderliegende frei drehbar gelagerte Rollen 10 auf, auf welchen die Substratauflagen 9 bewegbar sind. Vorzugsweise sind die beiden Reihen von Rollen 10 parallel zueinander ausgerichtet und beabstandet zueinander angeordnet. An ihrem der Druckeinrichtung 2 zugewandten Ende in Förderrichtung gesehen weist die Sammeleinrichtung 8 einen ersten Anschlag 11 auf, der in der Höhe verstellbar ist, wie durch einen Doppelpfeil gezeigt. In der ersten Position (durchgezogene Linie) liegt der Anschlag 11 oberhalb der Rollen 10 und damit im Bewegungsweg der Substratauflagen 9. Wird nun in der Fertigungsreihe, in welcher das Drucksystem 1 integriert ist, ein Substrat dem Drucksystem zugeführt, so gelangt es auf die Rollen 10 der Zuführeinrichtung 7. In Fördereinrichtung vorne weist die Zuführeinrichtung 7 bevorzugt eine oder mehrere antreibbare Rollen 12 auf, welche die ihr zugeführten Substratauflagen 9 in Richtung des Anschlags 11 antreiben, so dass diese über die frei drehbaren Rollen 10 bis zu dem Anschlag 11 rollen. So werden nach und nach mehrere Substratauflagen 9 in die Sammeleinrichtung 8 verbracht und dort an dem Anschlag 11 hintereinander aufgereiht. Durch das Antreiben der Rollen 12 bleiben die Substratauflagen 9 aneinander anliegend in Förderrichtung und bilden eine Substratauflagengruppe oder -einheit.

Zum Transportieren der Substratauflagen ist bevorzugt unterhalb der Rollen 10, 12 eine Fördereinrichtung 13 angeordnet, die zwischen den beiden Reihen von Rollen 10 und 12 liegt und sich parallel zu den Reihen erstreckt. Die Fördereinrichtung 13 weist einen Mitnahmeanschlag 14 auf, der translatorisch in Förderrichtung bewegbar ist. Dazu ist der Mitnahmeanschlag 14 beispielsweise auf einer Spindel eines Spindeltriebs angeordnet und durch die Rotation der Spindel translatorisch entlang der Spindel verlagerbar. Der Mitnahmeanschlag 14 ragt derart weit nach oben, dass er mit den auf den Rollen 10, 12 aufliegenden Substratauflagen 9 zusammenwirken kann, um diese mitzunehmen beispielsweise zum Sammeln der Substratauflagen 9 an dem Anschlag 11. Der Mitnahmeanschlag 14 wirkt dabei mit einem entsprechenden Gegenanschlag der jeweiligen Substratauflage 9, beispielsweise mit einer Seitenkante der jeweiligen Substratauflage 9 zusammen. Bevorzugt ist der Mitnahmeanschlag 14 derart weit verfahrbar, dass mittels des Mitnahmeanschlags 14 die Substratauflagen 9 der Druckeinrichtung 2 zugeführt werden können. Optional ist die Fördereinrichtung 13 oder zumindest der Mitnahmeanschlag 14 in der Höhe verstellbar, um ein Verlagern des Mitnahmeanschlags 14 unabhängig von gegebenenfalls auf den Rollen 10, 12 aufliegenden Substratauflagen 9 durchzuführen. Weiterhin weist das Drucksystem 1 eine Abführeinrichtung 15 auf, welche der Druckeinrichtung 2 nachgeschaltet ist. Die Abführeinrichtung 15 ist ähnlich wie die Zuführeinrichtung 7 aufgebaut und weist anstelle einer Sammeleinrichtung eine Vereinzelungseinrichtung 16 auf, die jedoch ähnlich wie die Sammeleinrichtung 8 ausgebildet ist. Auch die Vereinzelungseinrichtung 16 weist zumindest zwei parallel zueinander ausgerichtete und jeweils mehrere in Förderrichtung hintereinanderliegend angeordnete und frei drehbar gelagerte Rollen 17 aufweisende Reihen auf, über welche die Substratauflagen geschoben werden können. Optional sind eine oder mehrere in Förderrichtung vorne und/oder hinten liegende Rollen 18 der Rollen 17 mit einem Antrieb, insbesondere Schrittmotor, gekoppelt, um diese anzutreiben und eine Bewegung der Substratauflagen 9 vorzugeben. Bevorzugt sind die beiden Reihen von Rollen 17 beabstandet zueinander angeordnet. Alternativ oder zusätzlich weist auch die Abführeinrichtung 15 eine Fördereinrichtung 19 auf, die insbesondere entsprechend der Fördereinrichtung 13 ausgebildet ist und einen in Fördereinrichtung bewegbaren, insbesondere translatorisch verschiebbaren Mitnahmeanschlag 20 aufweist, der mit den Substratauflagen 9 zusammenwirken kann, um die Substratauflagen 9 zu verschieben beziehungsweise zu transportieren. Auch der Mitnahmeanschlag 20 ist bevorzugt in der Höhe verstellbar, um das Zusammenwirken mit den Substratauflagen 9 zu bewirken oder zu lösen.

Die Vereinzelungseinrichtung 16 weist weiterhin einen weiteren verlagerbaren Anschlag 21 auf, der in einer Sperrstellung oberhalb der Rollen 17, 18 im Bewegungsweg der Substratauflagen 9 liegt und damit als Sammelanschlag für die Substratauflagen 9 und zu deren Vereinzelung nutzbar ist. Der Anschlag 21 ist ebenfalls in der Höhe verstellbar und kann in eine Freigabestellung (gestrichelte Linie) verbracht werden, in welcher die Substrate über den Anschlag 21 hinweg förderbar sind. Durch eine koordinierte Ansteuerung des Anschlags 21 und der Fördereinrichtung 19 sind die Substratauflagen 19 nacheinander vereinzelt durch die Abführeinrichtung 15 aus dem Drucksystem entfernbar und beispielsweise einer weiteren Überarbeitungsstation sequenziell zuführbar.

Anhand von Figur 2 soll erläutert werden, wie das Drucksystem 1 funktioniert, so dass es einen hohen Durchsatz an Substraten und minimaler Stillstandzeiten der Druckeinrichtung 2 ermöglicht. Dazu zeigt Figur 2 das Drucksystem 1 in einer Draufsicht in mehreren Schritten A, B, C und D.

Die Ausgangssituation in Schritt A stellt sich wie folgt dar: in der Druckeinrichtung 2 befinden sich drei Substratauflagen 9, auf denen jeweils mehrere Substrate 22 angeordnet sind. Während die Substratauflagen 9 durch den Drucktisch 3 ausgerichtet und gegebenenfalls bereits durch den Druckkopf 4 bedruckt werden, wird der Zuführeinrichtung 7 aus der Fertigungsreihe eine Substratauflage 9 mit darauf angeordneten Substraten 22 zugeführt. Diese rollt über die Rollen 10 bis zu dem Anschlag 11 und wird gegebenenfalls durch die angetriebenen Rollen 12 und/oder die Fördereinrichtung 13 mittels des Mitnahmeanschlags 14 sicher bis zum Anschlag 11 transportiert.

In der Abführeinrichtung 15 befinden sich zu dem Zeitpunkt drei Substratauflagen 9, auf welchen Substrate 22 angeordnet sind, die bereits durch die Druckeinrichtung 2 bedruckt wurden und nebenher zur weiteren Verarbeitung zur Verfügung stehen. Während der Zuführeinrichtung 7 die erste Substratauflage 9 zugeführt wird, wird in der Abführeinrichtung 15 der Anschlag 21 in die Freigabeposition verlagert und nahe zu dem Anschlag 21 angeordnete Rollen 18 angetrieben oder die Fördereinrichtung 19 angesteuert, um die Substratauflage 9 in Förderrichtung beziehungsweise in Richtung des Anschlags 21 weiter zu bewegen. Vorteilhafterweise werden nur die Rollen 18 nahe zu dem Anschlag 21 angetrieben, so dass nur die dort beziehungsweise die an dem Anschlag 21 anliegende Substratauflage 9 befördert wird. Dadurch wird die Substratauflage 9 aus der Abführeinrichtung 15 herausgefördert und von der Substratauflageeinheit vereinzelt. Anschließend wird die Fördereinrichtung 19 angesteuert, um die verbleibenden Substratauflagen 9 in Förderrichtung mittels des Mitnahmeanschlags 20 zu bewegen, wobei nunmehr der Anschlag 21 wieder in die Sperrposition verlagert wird, so dass die verbleibenden Substratauflagen 9 an den Anschlag 21 treffen und an einer Weiterbewegung gehindert sind.

Im nächsten Schritt B wird das zuvor beschriebene Verfahren wiederholt, so dass eine zweite Substratauflage 9 der Zuführeinrichtung 7 zugeführt und auf den Rollen 10 gesammelt wird. Dazu wird die Substratauflage 9 bis an die dort bereits vorhandene Substratauflage 9 herangefördert, während die Druckeinrichtung 2 beispielsweise den Druckvorgang durchführt. Gleichzeitig wird eine zweite Substratauflage 9 der Substratauflageneinheit, die sich in der Abführeinrichtung 15 befindet, an dem Anschlag 21 vorbei weiter gefördert, wie zuvor beschrieben.

Im darauffolgenden Schritt C wiederholt sich das Verfahren erneut, so dass nunmehr sich drei Substratauflagen 9 in der Zuführeinrichtung 7 aneinander anliegend befinden, so dass diese eine Substratauflageneinheit 9 bilden, und die letzte verbleibende Substratauflage 9 in der Abführeinrichtung 15 wird aus dieser heraus transportiert.

Damit ist die Abführeinrichtung 15 frei von Substratauflagen 9 im Schritt D. Nach Beendigung des Druckvorgangs fördert die Druckeinrichtung 7 die dort nunmehr bedruckte Substratauflageneinheit in die Abführeinrichtung 15, wo sie an dem Anschlag 21 zum Stillstand kommt. Sobald die Substratauflageneinheit aus der Druckeinrichtung 2 entfernt wird, wird die in der Sammeleinrichtung 8 der Zuführeinrichtung 7 nunmehr zusammengestellte Substratauflageneinheit nach Verlagern des Anschlags 11 in die Freigabeposition in die Druckeinrichtung 2 gesammelt gefördert, so dass nunmehr die Zuführeinrichtung 7 frei von Substratauflagen ist und in der Druckeinrichtung 2 ein Druckvorgang durchgeführt werden kann. Hier beginnt das Verfahren von vorne in Schritt A.

Es zeigt sich, dass sich die vorteilhafte Ausgestaltung des Drucksystems 1 Substratauflagen 9 in Förderrichtung vor der Druckeinrichtung 2 gesammelt und in Förderrichtung nach der Druckeinrichtung 2 vereinzelt werden. Dadurch werden Substrateinheiten gebildet und aufgelöst, während eine Substrateinheit mit darauf befindlichen Substraten bedruckt wird. Damit stehen bereits nach erfolgtem Druckvorgang in kürzester Zeit eine Vielzahl von Substratauflagen 9 bereit, die für einen nächsten Druckvorgang benutzt werden kann. Hierdurch wird die Stillstandszeit der zweiten Druckeinrichtung 2 minimiert und ein hoher Durchsatz des Drucksystems ermöglicht.

Um die Betriebssicherheit zu erhöhen, weisen die Zuführeinrichtung 7 und die Abführeinrichtung 15 ebenfalls jeweils mindestens einen Sensor 23 beziehungsweise 24 auf, der die Anwesenheit und optional Anordnung der Substratauflagen in der jeweiligen Einrichtung überwacht und in Abhängigkeit der erfassten Anordnung und Ausrichtung die jeweiligen Fördermittel der Einrichtungen ansteuert. Durch das Vereinzeln der Substratauflagen 9 am Ende beziehungsweise in der Abführeinrichtung 17 wird nunmehr erreicht, dass die Substratauflagen 9 in regelmäßigen zeitlichen Abständen vereinzelt weiteren Bearbeitungseinrichtungen zugeführt werden. Die Gesamtbewegung einzelner Substratauflagen 9 in regelmäßigen Abständen wird somit durch das vorteilhafte Drucksystem nicht unterbrochen, wenn die Substratauflagen 9 durch die Abführeinrichtung 15 in der gleichen Taktung ausgegeben werden, wie sie von der Zuführeinrichtung 7 empfangen werden.

Anstelle von Substratauflagen 9 können auch Substrate 22 direkt durch die Zuführeinrichtung gesammelt, durch die Druckeinrichtung 2 bedruckt und durch die Abführeinrichtung vereinzelt werden. Das Zusammenstellen mehrerer Substrate auf einer Substratauflage 9 ist insoweit eine vorteilhafte Option, um den Transport einer Vielzahl von Substraten zu vereinfachen.

## Patentansprüche

1. Drucksystem (1) zum Bedrucken von Substraten (22), insbesondere Leiterplatten, Wafern oder Solarzellen, mit einer Druckeinrichtung (2), die einen Drucktisch (3), auf welchem die Substrate positionierbar sind, und einen dem Drucktisch (3) zugeordneten Druckkopf (4) zum Bedrucken der auf dem Drucktisch positionierten Substrate aufweist, mit einer Zuführeinrichtung (7) zum Zuführen der zu bedruckenden Substrate zu der Druckeinrichtung (2) und mit einer Abführeinrichtung (15) zum Abführen der bedruckten Substrate aus der Druckeinrichtung (2), und mit mehreren Substratauflagen (9), auf welchen jeweils mehrere Substrate auflegbar sind, und wobei Zuführeinrichtung (7), Druckeinrichtung (2) und Abführeinrichtung (15) dazu ausgebildet sind, die Substratauflagen (9) mit den darauf befindlichen Substraten zu befördern, **dadurch gekennzeichnet, dass** die Zuführeinrichtung (7) dazu ausgebildet ist, mehrere Substratauflagen (9) zu sammeln und gesammelt der Druckeinrichtung (2) zuzuführen, wobei die Druckeinrichtung (2) dazu ausgebildet ist, die Substrate auf den gesammelten Substratauflagen (9) zu bedrucken, und dass die Abführeinrichtung (15) dazu ausgebildet ist, diese gesammelten Substratauflagen (9) zu vereinzeln und abzuführen.

2. Drucksystem nach Anspruch 1, **dadurch gekennzeichnet, dass** die Zuführeinrichtung (7) eine Sammeleinrichtung (8) aufweist, die einen verlagerbaren Anschlag (11) aufweist, gegen welchen die Substratauflagen (9) zum Sammeln förderbar sind.

3. Drucksystem nach einem der vorhergehenden Ansprüche, **dadurch gekennzeichnet, dass** die Sammeleinrichtung (8) mehrere frei drehbar gelagerte Rollen (10) aufweist, auf welchen die Substratauflagen (9) sammelbar sind.

4. Drucksystem nach einem der vorhergehenden Ansprüche, **dadurch gekennzeichnet, dass** die Zuführeinrichtung (7) eine Fördereinrichtung (13) zum Fördern der insbesondere gesammelten Substratauflagen (9) in die Druckeinrichtung (2) aufweist.

5. Drucksystem nach Anspruch 4, **dadurch gekennzeichnet, dass** die Fördereinrichtung (13) einen verschiebbaren Mitnahmeanschlag (14) zumindest einen antreibbaren Förderriemen und/oder zumindest eine angetriebene Förderrolle (12) aufweist.

6. Drucksystem nach einem der vorhergehenden Ansprüche, **dadurch gekennzeichnet, dass** der Drucktisch (4) Mittel zum Transportieren und Ausrichten der Substratauflagen (9) aufweist.

7. Drucksystem nach einem der vorhergehenden Ansprüche, **dadurch gekennzeichnet, dass** der Drucktisch (3) zumindest einen verlagerbaren Anschlag (25) aufweist, gegen welchen die Substratauflagen (9) förderbar sind.

8. Drucksystem nach einem der vorhergehenden Ansprüche, **dadurch gekennzeichnet, dass** die Abführeinrichtung (15) mehrere frei drehbar gelagerte Rollen (18) zur Aufnahme der Substratauflagen (9) von der Druckeinrichtung (2) und zum Transport der Substratauflagen (9) aufweist.

9. Drucksystem nach einem der vorhergehenden Ansprüche, **dadurch gekennzeichnet, dass** die Abführeinrichtung (15) eine Vereinzelungseinrichtung (16) zum Vereinzeln und Abführen der Substratauflagen (9) aufweist.

10. Drucksystem nach Anspruch 9, **dadurch gekennzeichnet, dass** die Vereinzelungseinrichtung (16) einen verlagerbaren Anschlag (21) aufweist, gegen welchen die Substratauflagen (9) förderbar sind.

11. Drucksystem nach einem der vorhergehenden Ansprüche, **dadurch gekennzeichnet, dass** die Abführeinrichtung (15) eine Fördereinrichtung (19) aufweist, die zumindest einen verschiebbaren Mitnahmeanschlag (20), zumindest einen antreibbaren Förderriemen und/oder zumindest eine angetriebene Förderrolle (18) aufweist.

12. Drucksystem nach einem der vorhergehenden Ansprüche, **dadurch gekennzeichnet, dass** die Druckeinrichtung (2), die Zuführeinrichtung (7) und die Abführeinrichtung (15) dazu ausgebildet sind, die Substratauflagen (9) in Förderrichtung hintereinander zu sammeln und als Substratauflageneinheit hintereinanderliegend zu transportieren.

13. Drucksystem nach einem der vorhergehenden Ansprüche, **dadurch gekennzeichnet, dass** die Zuführeinrichtung (7), die Druckeinrichtung (2) und die Abführeinrichtung (15)j eweils zumindest einen Sensor (6,23,24) zum Erfassen zumindest einer Substratauflage (9) aufweisen.

14. Verfahren zum Betreiben eines Drucksystem (1), das gemäß einem der Ansprüche 1 bis 13 ausgebildet ist, mit folgenden Schritten:
a) Sammeln mehrerer Substratauflagen (9) in der Zuführeinrichtung (7) in Förderrichtung gesehen hintereinander,
b) Transportieren der gesammelten Substratauflagen (9) in die Druckeinrichtung (2),
c) Bedrucken der gesammelten Substratauflagen (9) in der Druckeinrichtung (2),
d) Transportieren der gesammelten Substratauflagen (9) in die Abführeinrichtung (15),
e) Vereinzeln und nacheinander Abführen der Substratauflagen (9) aus der Abführeinrichtung (15).

15. Verfahren nach Anspruch 14, **dadurch gekennzeichnet, dass** die Schritte a), c) und e) gleichzeitig durchgeführt werden.

## Claims

1. Printing system (1) for printing substrates (22), in particular printed circuit boards, wafers or solar cells, with a printing device (2) which has a printing table (3) on which the substrates can be positioned, and a print head (4), associated with the printing table (3), for printing the substrates positioned on the printing table, with a feed device (7) for feeding the substrates to be printed to the printing device (2) and a discharge device (15) for discharging the printed substrates from the printing device (2), and with a plurality of substrate supports (9), on each of which a plurality of substrates can be placed, and wherein feed device (7), printing device (2) and discharge device (15) are designed to convey the substrate supports (9) together with the substrates located thereon, **characterized in that** the feed device (7) is designed to collect and feed a plurality of substrate supports (9) collected to the printing device (2), wherein the printing device (2) is designed to print the substrates on the collected substrate supports (9), and **in that** the discharge device (15) is designed to separate and discharge these collected substrate supports (9).

2. Printing system according to claim 1, **characterized in that** the feed device (7) comprises a collection device (8) which comprises a displaceable stop (11) against which the substrate supports (9) can be conveyed for collection.

3. Printing system according to one of the preceding claims, **characterized in that** the collection device (8) comprises a plurality of freely rotatably mounted rollers (10) on which the substrate supports (9) can be collected.

4. Printing system according to one of the preceding claims, **characterized in that** the feed device (7) comprises a conveying device (13) for conveying the in particular collected substrate supports (9) into the printing device (2).

5. Printing system according to claim 4, **characterized in that** the conveying device (13) comprises a displaceable driver stop (14), at least one drivable conveying belt and/or at least one driven conveying roller (12).

6. Printing system according to one of the preceding claims, **characterized in that** the printing table (4) comprises means for transporting and aligning the substrate supports (9).

7. Printing system according to one of the preceding claims, **characterized in that** the printing table (3) comprises at least one displaceable stop (25) against which the substrate supports (9) can be conveyed.

8. Printing system according to one of the preceding claims, **characterized in that** the removal device (15) comprises a plurality of freely rotatably mounted rollers (18) for receiving the substrate supports (9) from the printing device (2) and for transporting the substrate supports (9).

9. Printing system according to one of the preceding claims, **characterized in that** the discharge device (15) comprises a separation device (16) for separating and discharging the substrate supports (9).

10. Printing system according to claim 9, **characterized in that** the separation device (16) comprises a displaceable stop (21) against which the substrate supports (9) can be conveyed.

11. Printing system according to one of the preceding claims, **characterized in that** the discharge device (15) comprises a conveying device (19) which comprises at least one displaceable driver stop (20), at least one drivable conveying belt and/or at least one driven conveying roller (18).

12. Printing system according to one of the preceding claims, **characterized in that** the printing device (2), the feed device (7) and the discharge device (15) are designed to collect the substrate supports (9) one behind the other in the conveying direction and to transport them lying one behind the other as a substrate support unit.

13. Printing system according to one of the preceding claims, **characterized in that** the feed device (7), the printing device (2) and the discharge device (15) each comprise at least one sensor (6, 23, 24) for detecting at least one substrate support (9).

14. Method for operating a printing system (1) configured according to any one of claims 1 to 13, comprising the following steps:
a) collecting a plurality of substrate supports (9) in the feed device (7) one behind the other, as seen in the conveying direction,
b) transporting the collected substrate supports (9) into the printing device (2),
c) printing the collected substrate supports (9) in the printing device (2),
d) transporting the collected substrate supports (9) into the discharge device (15),
e) separating and successively discharging the substrate supports (9) out of the discharge device (15).

15. Method according to claim 14, **characterized in that** steps a), c) and e) are carried out simultaneously.

## Revendications

1. Système d'impression (1) pour imprimer des substrats (22), en particulier des cartes de circuits imprimés, des plaquettes ou des cellules solaires, avec un dispositif d'impression (2) qui présente une table d'impression (3) sur laquelle les substrats peuvent être positionnés, et une tête d'impression (4) associée à la table d'impression (3) pour imprimer les substrats positionnés sur la table d'impression, avec un dispositif d'alimentation (7) pour amener les substrats à imprimer au dispositif d'impression (2) et avec un dispositif d'évacuation (15) pour évacuer les substrats imprimés du dispositif d'impression (2), et avec plusieurs couches de substrats (9) sur lesquels plusieurs substrats peuvent respectivement être posés, et le dispositif d'alimentation (7), le dispositif d'impression (2) et le dispositif d'évacuation (15) étant conçus pour transporter les couches de substrats (9) avec les substrats qui s'y trouvent, **caractérisé en ce que** le dispositif d'alimentation (7) est conçu pour rassembler plusieurs couches de substrats (9) et de les amener rassemblées au dispositif d'impression (2), le dispositif d'impression (2) étant conçu pour imprimer les substrats sur les couches de substrats (9) rassemblées, et **en ce que** le dispositif d'évacuation (15) est conçu pour séparer et évacuer ces couches de substrats (9) rassemblées.

2. Système d'impression selon la revendication 1, **caractérisé en ce que** le dispositif d'alimentation (7) comporte un dispositif de collecte (8) qui présente une butée déplaçable (11) contre laquelle les couches de substrat (9) peuvent être transportés pour être collectés.

3. Système d'impression selon l'une des revendications précédentes, **caractérisé en ce que** le dispositif de collecte (8) comporte plusieurs rouleaux (10) montés libres en rotation, sur lesquels les couches de substrat (9) peuvent être collectés.

4. Système d'impression selon l'une des revendications précédentes, **caractérisé en ce que** le dispositif d'alimentation (7) comporte un dispositif de transport (13) pour acheminer les couches de substrats (9), notamment collectés, dans le dispositif d'impression (2).

5. Système d'impression selon la revendication 4, **caractérisé en ce que** le dispositif de transport (13) présente une butée d'entraînement (14) déplaçable, au moins une courroie de transport pouvant être entraînée et/ou au moins un rouleau de transport (12) entraîné.

6. Système d'impression selon l'une des revendications précédentes, **caractérisé en ce que** la table d'impression (4) comporte des moyens de transport et d'alignement des couches de substrat (9).

7. Système d'impression selon l'une des revendications précédentes, **caractérisé en ce que** la table d'impression (3) comporte au moins une butée (25) déplaçable contre laquelle les couches de substrat (9) peuvent être transportés.

8. Système d'impression selon l'une des revendications précédentes, **caractérisé en ce que** le dispositif d'évacuation (15) comporte plusieurs rouleaux (18) montés libres en rotation pour recevoir les couches de substrat (9) du dispositif d'impression (2) et pour transporter les couches de substrat (9).

9. Système d'impression selon l'une des revendications précédentes, **caractérisé en ce que** le dispositif d'évacuation (15) comporte un dispositif de séparation (16) pour séparer et évacuer les couches de substrats (9).

10. Système d'impression selon la revendication 9, **caractérisé en ce que** le dispositif de séparation (16) présente une butée (21) déplaçable, contre laquelle les couches de substrat (9) peuvent être transportés.

11. Système d'impression selon l'une des revendications précédentes, **caractérisé en ce que** le dispositif d'évacuation (15) présente un dispositif de transport (19) qui présente au moins une butée d'entraînement (20) déplaçable, au moins une courroie de transport pouvant être entraînée et/ou au moins un rouleau de transport (18) entraîné.

12. Système d'impression selon l'une des revendications précédentes, **caractérisé en ce que** le dispositif d'impression (2), le dispositif d'alimentation (7) et le dispositif d'évacuation (15) sont conçus pour rassembler les couches de substrat (9) les uns derrière les autres dans la direction de transport et pour les transporter les uns derrière les autres en tant qu'unité de couche de substrat.

13. Système d'impression selon l'une des revendications précédentes, **caractérisé en ce que** le dispositif d'alimentation (7), le dispositif d'impression (2) et le dispositif d'évacuation (15) présentent chacun au moins un capteur (6, 23, 24) pour détecter au moins une couche de substrat (9).

14. Procédé de fonctionnement d'un système d'impression (1) réalisé selon l'une des revendications 1 à 13, comprenant les étapes suivantes :
a) collecte de plusieurs couches de substrat (9) dans le dispositif d'alimentation (7), les uns derrière les autres, vu dans la direction de transport,
b) transport des couches de substrat collectées (9) dans le dispositif d'impression (2),
c) impression des couches de substrat collectées (9) dans le dispositif d'impression (2),
d) transport des couches de substrat collectées (9) dans le dispositif d'évacuation (15),
e) séparation et évacuation successive des couches de substrat (9) hors du dispositif d'évacuation (15).

15. Procédé selon la revendication 14, **caractérisé en ce que** les étapes a), c) et e) sont réalisées simultanément.
